(19) Europäisches Patentamt
European Patent Office
Office européen des brevets

(11) **EP 2 564 414 B1**

(12) **FASCICULE DE BREVET EUROPEEN**

(45) Date de publication et mention de la délivrance du brevet:
**19.02.2014 Bulletin 2014/08**

(51) Int Cl.:
*H01L 31/18* (2006.01)     *H01L 31/0236* (2006.01)
*H01L 21/67* (2006.01)

(21) Numéro de dépôt: **11719784.8**

(22) Date de dépôt: **27.04.2011**

(86) Numéro de dépôt international:
**PCT/EP2011/056660**

(87) Numéro de publication internationale:
**WO 2011/134999 (03.11.2011 Gazette 2011/44)**

(54) **DISPOSITIF ET PROCEDE DE TEXTURATION MECANIQUE D'UNE PLAQUETTE DE SILICIUM DESTINEE A CONSTITUER UNE CELLULE PHOTOVOLTAIQUE**

VORRICHTUNG UND VERFAHREN ZUR MECHANISCHEN TEXTURIERUNG EINES SILICIUMWAFERS FÜR EINE PV-ZELLE

DEVICE AND METHOD FOR MECHANICALLY TEXTURING A SILICON WAFER INTENDED TO COMPRISE A PHOTOVOLTAIC CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.04.2010 FR 1053268**

(43) Date de publication de la demande:
**06.03.2013 Bulletin 2013/10**

(73) Titulaire: **Commissariat à l'Énergie Atomique et aux Énergies Alternatives
75015 Paris (FR)**

(72) Inventeurs:
• **GARANDET, Jean-Paul
F-73370 Le Bourget-du-Lac (FR)**
• **BANCILLON, Jacky
F-38120 Saint-Egreve (FR)**
• **FEDERZONI, Luc
F-38300 Bourgoin-Jallieu (FR)**
• **PIROT, Marc
F-73610 Attignat Oncin (FR)**

(74) Mandataire: **Ilgart, Jean-Christophe et al
BREVALEX
95 rue d'Amsterdam
75378 Paris Cedex 8 (FR)**

(56) Documents cités:
EP-A2- 0 969 519     FR-A1- 2 620 269
US-A- 4 194 094      US-A- 5 238 879
US-A- 5 378 289      US-A- 5 704 992
US-A- 6 084 175

• FATH P ET AL: "Progress in a novel high-throughput mechanical texturization technology for highly efficient multicrystalline silicon solar cells", 1 novembre 1997 (1997-11-01), SOLAR ENERGY MATERIALS AND SOLAR CELLS, ELSEVIER SCIENCE PUBLISHERS, AMSTERDAM, NL, PAGE(S) 229 - 236, XP004111853, ISSN: 0927-0248 cité dans la demande le document en entier
• SANTINACCI L ET AL: "AFM scratching and metal deposition through insulating layers on silicon", SURFACE SCIENCE, NORTH-HOLLAND PUBLISHING CO, AMSTERDAM, NL, vol. 597, no. 1-3, 15 décembre 2005 (2005-12-15), pages 11-19, XP025381564, ISSN: 0039-6028 [extrait le 2005-12-15]

**Description**

**DOMAINE TECHNIQUE**

L'invention concerne un dispositif et un procédé de texturation d'une plaquette de silicium destinée à constituer une cellule photovoltaïque.

Elle concerne également une plaquette de silicium obtenue, en particulier une plaquette multi cristallin.

**ART ANTÉRIEUR**

Les cellules photovoltaïques (PV) sont majoritairement fabriquées à partir de silicium mono ou multi cristallin dans des filières qui mettent en jeu le traitement de plaquettes de silicium dans un environnement de salle blanche. La première de cette étape est une texturation de la surface de la plaquette destinée à diminuer sa réflectivité.

Dans le procédé standard utilisé au niveau industriel, les lingots cristallisés sont découpés par sciage à fil en plaquettes qui sont texturées par attaque chimique pour améliorer le piégeage de la lumière. Pour optimiser le procédé, on vise généralement à obtenir des structures ayant pour taille quelques microns. Cette attaque chimique peut être réalisée soit en milieu acide, soit en milieu basique.

Dans les deux cas précités, la technique permet effectivement de diminuer la réflectivité, mais son inconvénient est de nécessiter le retraitement de quantités importantes d'effluents chimiques.

Une voie alternative, basée sur un procédé de gravage mécanique (outil structurant constitué d'une pièce métallique micro-usinée avec des rayures en forme de V et revêtu d'une couche abrasive constituée de grains diamant) a été proposé par l'Université de Constance [1]. Le procédé a fait la preuve de son efficacité et de sa capacité à ne pas provoquer de défauts de nature à affecter les rendements de conversion énergétique des cellules PV. Par ailleurs les problèmes de productivité (durée de traitement de quelques secondes par plaque) et de l'usure des outils de structure ont été résolus. Cependant des problèmes d'usinage (notamment pour ce qui concerne le rayon de courbure des pointes) et de granulométrie des poudres diamant limitent l'efficacité du procédé. Dans la pratique, la résolution spatiale de la gravure reste limitée en standard à des valeurs de l'ordre de 50 $\mu$m.

A l'autre extrême en termes d'échelle, on peut citer les travaux réalisés par gravage avec une pointe AFM [2]. Il est alors possible d'obtenir des motifs extrêmement fins, et dont les faciès sont très propres à l'échelle submicronique. Cependant, les vitesses de déplacement de la pointe sont très lentes (au mieux la centaine de microns par seconde) et donc incompatibles avec une procédé industriel.

Il n'existe donc pas de procédé simple et efficace permettant le gravage à grande vitesse de plaquettes de silicium pour former des textures de taille caractéristique aux alentours de la dizaine de microns. Le problème est encore plus complexe du fait que la découpe des lingots par scie à fil induit des variations d'épaisseur, qui dans le procédé classique d'abrasion par des particules de carbure de silicium, sont de l'ordre de 30-40 $\mu$m [3]. Même avec des procédés plus sophistiqués et plus coûteux avec des particules de diamant, il semble difficile de descendre en deçà d'une profondeur de 10 $\mu$m [3].

En outre, il est généralement procédé à un prétraitement chimique permettant d'éliminer la zone écrouie suite à la découpe. Du fait de cinétiques d'attaques différentes selon les grains cristallins, ce prétraitement a également pour effet d'augmenter la rugosité des plaquettes. En conclusion, les variations de cotes sur les plaquettes prêtes à être texturées sont sauf cas exceptionnel significativement supérieures à 10 $\mu$m.

Dans ces conditions, aucune des techniques proposées dans la littérature ne permet de réaliser une texturation mécanique d'une plaquette de silicium avec des motifs de gravage d'une profondeur de l'ordre de la dizaine de $\mu$m.

Le but de l'invention est donc de proposer une solution pour réaliser une texturation d'une plaquette de silicium avec des motifs de gravage uniformes de taille caractéristique comprise entre 5 et 50 $\mu$m sur une surface susceptible de présenter des défauts de planéité entre 5 et 50 $\mu$m à des vitesses compatibles avec les impératifs de production des usines de cellules PV, typiquement une durée de texturation de quelques secondes par plaquette de silicium.

Un but plus général est de proposer une solution simple à mettre en oeuvre et efficace.

**EXPOSÉ DE L'INVENTION**

Pour ce faire, l'invention a pour objet un dispositif de texturation mécanique d'une plaquette de silicium, destinée à constituer une cellule photovoltaïque, comprenant une pluralité de pointes en carbure de tungstène et un support comprenant une pluralité de logements adaptés chacun pour loger avec coulissement une pointe en carbure de tungstène, et des moyens pour maintenir en appui chacune de la pluralité des pointes contre la plaquette de silicium selon une force constante indépendante des variations d'épaisseur de ladite plaquette.

De préférence, le support est adapté pour loger avec coulissement libre les pointes. Les moyens de maintien en appui sont alors avantageusement constitués par le poids propre de chacune des pointes.

Autrement dit selon l'invention, on réalise une texturation par gravage mécanique en utilisant un système d'autorégulation de la force d'appui adapté à la texturation de plaquettes de silicium non planes à l'échelle de quelques dizaines de micromètres.

Pour résoudre la difficulté liée aux défauts de planéité, l'invention utilise un système où la pluralité des pointes gravantes coulisse librement pour suivre les changements de niveau de la surface à graver. La force d'appui reste donc égale au poids de la pointe quelque soit le niveau géométrique de la surface à graver. Le déplacement vertical des pointes est guidé par un support.

On peut considérer que le principe du gravage utilisant une masse pesante est connu [4], mais la solution selon ce document [4], US 4821250A est appliquée localement par une pointe pour graver un sillon. Or, une spécificité du problème à la base de l'invention est la nécessité de texturer de façon collective, c'est-à-dire simultanément sur toute la surface à graver, une plaquette de silicium pour tenir la spécification de durée de texturation.

Ainsi, le dispositif selon l'invention comprend une pièce de structure (support) avec des logements où sont insérées les pointes. Ces logements sont décalés les uns par rapport aux autres d'une distance d définissant le pas de gravage. Les logements sont séparés les uns des autres pour assurer la cohésion mécanique de l'ensemble. La partie inférieure des logements est en forme de trapèze, avec un angle au sommet supérieur à celui des pointes pour permettre leur coulissement vertical.

Pour obtenir des profils de gravure d'une profondeur de l'ordre de 5-20 $\mu$m, typique de ce qui est classiquement mis en oeuvre pour les applications PV, une force d'appui comprise entre 0.1 et 2 N, préférentiellement 0.3 à 1 N, est préférée. Or, il n'était pas du tout évident que les plaquettes de silicium puissent tenir sous la contrainte, mais les tests réalisés montrent que c'est le cas sans problème jusqu'à des forces d'appui de 2 N, sauf dans le cas de plaquettes présentant des amorces de rupture importantes.

Une autre difficulté porte sur l'encombrement géométrique du système. En effet, les dimensions des pointes (assimilées à des parallélépipèdes de base Lxl et de hauteur H) et celles de la zone gravante A et B sont liées par les équations suivantes :

$$k \ x \ (L+el)=A \ et \ n \ x \ (1 + e2) = B.$$

Le dispositif est également spécifié par la contrainte du pas de gravage d selon :

$$nxd=L+el.$$

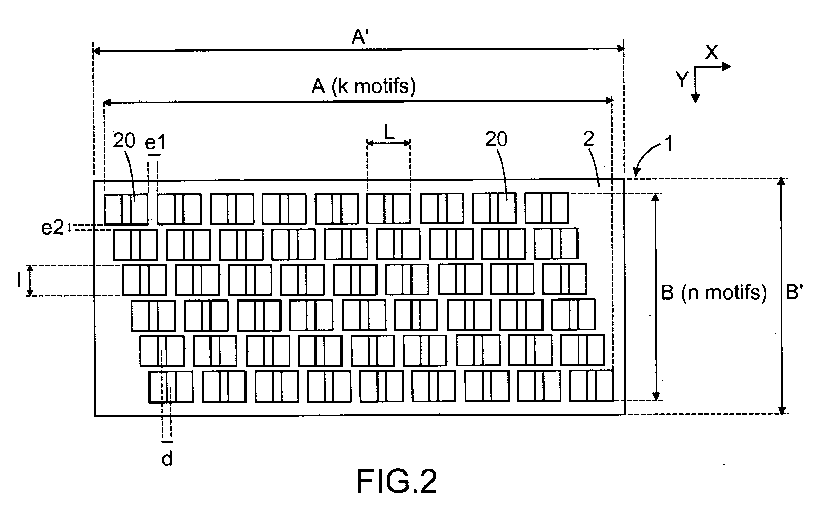

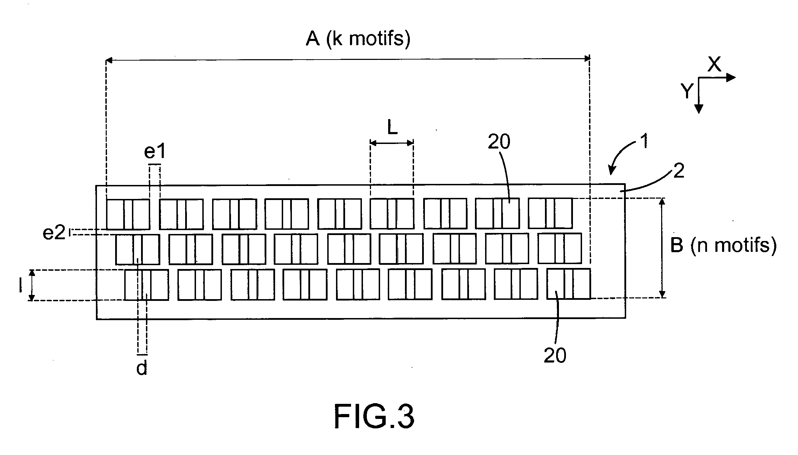

Les références des lettres utilisées pour définir les dimensions et les entiers sont montrées en figures 2 et 3.

La longueur A est fixée par la dimension des plaquettes à texturer, typiquement A = 15 cm. Pour fixer les idées, en prenant des valeurs raisonnables pour les dimensions des logements et des espacements, L = 4 mm, 1= 2 mm, e1 = e2 = 1 mm et un pas de gravage d de 20 $\mu$m, les relations précédentes donnent :

$$k = 30, \ n = 250, \ B = 0.75 \ m.$$

Or, si une telle valeur de B peut paraître élevée, elle est tout à fait acceptable pour une application industrielle, surtout si il est possible de texturer plusieurs plaques alignées selon la direction Y. Il existe par ailleurs deux possibilités pour réduire la dimension B: une texturation en plusieurs passes avec décalage de l'outil dans la direction X perpendiculaire à la direction de gravage Y (voir les références des directions en figures 2 et 3).

Cela revient à redéfinir la condition d'égalité ci-dessus :

$$n \ x \ d = (L + el),$$

en n x d = (L + el)/j ou j est un nombre entier.

A L donné, on peut donc réduire n et donc B d'un facteur j. Cependant, pour des raisons de productivité, cette solution n'est pas réaliste pour des valeurs de j supérieures à 3.

Une autre option pour réduire B serait de diminuer la dimension 1, mais se pose alors le problème d'atteindre une masse raisonnable sans nécessiter une hauteur H rédhibitoire.

En effet, avec un matériau comme le carbure de silicium de masse volumique p de l'ordre de 3.2 kg/m³, atteindre une force de 0.5 N avec un parallélépipède de base 4 x 2 mm² nécessiterait une hauteur de près de 2 m, ce qui pose des problèmes évidents d'encombrement du dispositif et de fragilité des pointes. Il s'agit d'un problème fondamental que même un maintien de B à une valeur maximale de 0.75 m et une texturation en j = 5 passes ne permettrait pas de résoudre ces problèmes. En effet, en gardant les valeurs L = 4 mm, el = 1 mm et un pas de gravage d de 20 $\mu$m, on trouve k = 30 et n = 50. En gardant B = 0.75 m et e2 = 1 mm, on pourrait prendre 1= 1.4 cm, à comparer aux 2 mm du cas précédent.

Même dans ces conditions extrêmes et non réalistes pour des configurations industrielles, on aurait quand même une valeur de H supérieure à 28 cm, qui serait encore une fois limite pour des questions d'encombrement du dispositif et de fragilité des pointes. L'utilisation de diamant ($\rho$ = 3.5 kg/m³) pose un problème de coût et ne permet qu'une amélioration limitée (réduction de H de seulement 10 %).

Les matériaux durs réputés pour être compatibles avec le silicium (diamant, carbure de silicium) ne sont donc pas adaptés à la mise en oeuvre de l'invention.

Pour répondre à cette difficulté, les inventeurs ont décidé de tester comme matériau gravant le carbure de tungstène, dont la densité supérieure à 15 kg/m³ permet une réelle rupture par rapport au diamant ou au carbure de silicium. Or, il n'était pas du tout évident d'utiliser ce matériau entant que matériau de gravure de plaquettes de silicium pour des applications PV, car le tungstène est parmi les métaux les plus néfastes à la durée de vie des porteurs minoritaires et donc au rendement des cellules PV [5]. A titre d'exemple, une teneur de l'ordre de la partie par milliard (ppb, ou de façon équivalente 5*1013 at/cm³) suffit à réduire de plus de 40 % le rendement d'une cellule PV dans le silicium de type p. Cependant, les essais réalisés ont permis de montrer que les propriétés électroniques des plaquettes n'étaient pas affectées, ce qui valide le choix du carbure de tungstène.

Dans la mise en oeuvre de l'invention, la partie inférieure des pointes se présente sous la forme d'un prisme droit de base triangulaire, l'angle au sommet du triangle étant choisi dans l'intervalle 20°-60°, avantageusement 30°-45°. La partie supérieure des pointes est préférentiellement un parallélépipède, mais d'autres formes peuvent être envisagées. Pour une forme parallélépipédique, les dimensions caractéristiques sont :

- longueur L de 2 à 15 mm,
- largeur 1 de 1 à 5 mm,
- hauteur H de 1 à 25 cm.

Le pas de gravage d défini comme étant la distance séparant deux pointes adjacentes est choisi de préférence entre 5 $\mu$m et 100 $\mu$m, préférentiellement entre 5 $\mu$m et 40 $\mu$m.

La vitesse de déplacement est comprise entre 5 et 100 mm/s, préférentiellement de 10 à 30 mm/s.

La pièce de structure est réalisée de préférence dans des matériaux de type acier ou superalliage base nickel. Il est à noter que quelle que soit la configuration choisie, le nombre de pointes gravantes par plaque sera très élevé, typiquement toujours de plusieurs milliers. On peut donc avantageusement automatiser l'insertion des pointes dans leur logement respectif.

Dans une variante de l'invention, une pression gazeuse est appliquée sur les pointes pour augmenter la force d'appui. A titre d'exemple, une pression de 1 bar agissant sur une surface de 10 mm² correspond à une force de 1 N. Ce mode de fonctionnement permet de préserver le principe d'une force d'appui indépendante du niveau géométrique de la plaque à graver, mais on retrouve encore une fois la nécessité d'avoir des pointes de surface L x 1 suffisante.

L'invention a entre autres comme avantages :

- possibilité d'accéder à des profils de texturation autres que les pyramides pour permettre l'optimisation du piégeage de la lumière : ces différents profils pourront être atteints en choisissant différentes formes géométriques des pointes,
- possibilité d'ajuster la force d'appui enjouant sur les caractéristiques géométriques des pointes,
- les pointes qui sont des pièces d'usure peuvent être fabriquées avec les technologies bas coût de type métallurgie des poudres,
- associé à un traitement d'image permettant d'identifier à partir du faciès de la plaquette les gravures défectueuses, le procédé permet le remplacement sélectif des seules pointes usées,
- temps de texturation très réduit et possibilité de texturer à la fois plusieurs plaquettes positionnées contigües selon la direction Y.

L'invention vise donc particulièrement une plaquette de silicium multi cristallin, destinée à constituer une cellule photovoltaïque, dont la surface comprend des motifs de gravage uniformes de profondeur comprise entre 5 et 50 $\mu$m.

## BRÈVE DESCRIPTION DES DESSINS

D'autres avantages et caractéristiques ressortiront mieux à la lecture de la description faite à titre illustratif en référence aux figures suivantes parmi lesquelles :

- la figure 1 est une vue schématique en coupe transversale d'un dispositif selon l'invention,
- la figure 2 est une vue de dessus d'un dispositif selon l'invention selon un mode de réalisation,
- la figure 3 est une vue de dessus d'un dispositif selon l'invention selon un autre mode de réalisation.

## EXPOSÉ DÉTAILLÉ DE MODES DE RÉALISATION PARTICULIERS

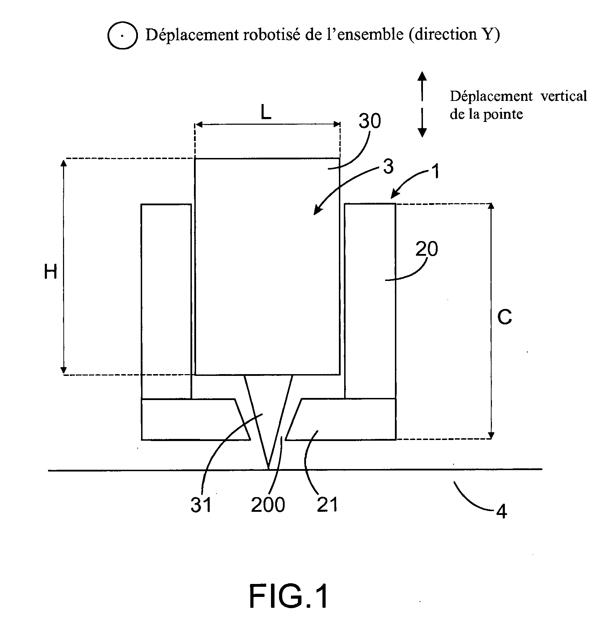

Comme montré en figure 1, un dispositif selon l'invention 1 comprend un support 2 dans lequel sont logés avec coulissement libre une pluralité de pointes identiques 3.

Les logements 20 sont de forme parallélépipédique dans leur partie supérieure et avec un angle au sommet 200 d'une forme de trapèze dans leur partie inférieure 21.

La partie supérieure 30 des pointes est de forme parallélépipédique et la partie inférieure 31 est un prisme droit de forme triangulaire.

En position de gravage, la partie triangulaire 31 des pointes 3 est en appui contre une plaquette de silicium 4 avec une force constante indépendante des variations d' épaisseur de la plaquette 4.

Les pointes sont réalisées en carbure de tungstène de préférence par une technologie de frittage.

L'angle au sommet de la partie inférieure triangulaire 31 pointes est de 30° inférieure à celui 200 de la partie inférieure 21 du support 2.

Les dimensions de la partie parallélépipédique supérieure 30 des pointes 3 sont typiquement :

L = 5 mm, 1 = 2 mm et H = 20 cm.

Les logements 20 pour les pointes sont séparés de e1 = e2 = 1 mm. Avec une densité typique du carbure de tungstène p de l'ordre de 15 kg/m$^3$, on arrive à une masse de 30 g par pointe 3 et donc une force d'appui par le poids propre de chaque pointe de l'ordre de 0.3 N.

La texturation est réalisée avantageusement en trois passes avec un pas d de 20 $\mu$m. Elle peut aussi être réalisée en une seule passe grâce à un dispositif selon la figure 2 ou deux passes avec un dispositif selon la figure 3.

Dans le cas de la texturation en trois passes, la pièce de structure ou support 2 est réalisée en acier inoxydable, avec une zone fonctionnelle, c'est-à-dire celle correspondant à la zone à graver de dimensions A = 15 cm et B = 30 cm. Les dimensions extérieures du support 2 sont A'= 20 cm, B' = 35 cm et C = 15 cm. Les différences entre A et A' d'une part et B et B' d'autre part sont liées à un renforcement mécanique du support 2 autour de la surface AxB comprenant les logements 20 des pointes gravantes 3 en carbure de tungstène.

Le dispositif avec ses pointes 3 logées dans son support 2 est positionné sur deux plaquettes de silicium de dimensions 15x15 cm$^2$ mises bout à bout.

Le support 2 est alors déplacé à une vitesse de 20 mm/s au dessus des deux plaquettes bout-à-bout pour réaliser la texturation. Les résidus de gravage sont éliminés par soufflage à l'air comprimé.

Un rinçage léger dans une solution acide peut également être mis en oeuvre.

## Références citées

[1] : P. Fath, C. Borst, C. Zechner, E. Bucher, G. Willeke, S. Narayanan, "Progress in a novel high-throughput mechanical texturization technology for highly efficient multicrystalline silicon solar cells", Solar Energy Materials and Solar Cells 48 (1997) 229-236 ;

[2] : L Santinacci, T Djenizian, P Schwauer, T Suter, A Etcheberry and P Schmuki, "Selective electrochemical gold deposition onto p-Si (100) surfaces", J. Phys. D: Appl. Phys. 41 (2008) 175301 ;

[3] : D. Kray, M. Schumann, A. Eyer, G. P. Willeke, R. Kübler, J. Beinert and G. Kleer, "Solar wafer slicing with loose and fixed grains", Proc. 2006 'IEEE 4th World Conference on Photovoltaic Energy Conversion, May 7-12 2006, Hawai, Vol. 1,948-951 ;

[4] : Brevet US 4821250A intitulé *"Process and apparatus for the recording of an information signal"* ;

[5] : J.R. Davis, Jr et al. « Impurities in silicon solar cells », IEEE Transactions on Electron Devices 27 (1980) 677-687.

**Revendications**

1. Dispositif (1) de texturation mécanique d'une plaquette de silicium (4), destinée à constituer une cellule photovoltaïque, comprenant une pluralité de pointes (3, 30, 31) en carbure de tungstène et un support (2) comprenant une pluralité de logements (20) adaptés chacun pour loger avec coulissement une pointe en carbure de tungstène, et des moyens pour maintenir en appui chacune de la pluralité des pointes contre la plaquette de silicium selon une force constante indépendante des variations d'épaisseur de ladite plaquette.

2. Dispositif selon la revendication 1, dans lequel le support est adapté pour loger avec coulissement libre les pointes.

3. Dispositif selon la revendication 2, dans lequel les moyens de maintien en appui sont constitués par le poids propre de chacune des pointes (3, 30, 31).

4. Dispositif selon l'une des revendications 1 à 3, dans lequel les pointes ont une partie inférieure (31) sous la forme d'un prisme droit à base triangulaire dont l'angle au sommet est inférieur à celui (200) des logements (20) adaptés pour les loger.

5. Dispositif selon la revendication 4, dans lequel l'angle au sommet du triangle des pointes (31) est compris entre 30 et 45°.

6. Dispositif selon l'une des revendications précédentes, dans lequel le pas de gravage d est compris entre 5 $\mu$m et 40 $\mu$m.

7. Procédé de texturation mécanique d'une plaquette de silicium (4), destinée à constituer une cellule photovoltaïque, mis en oeuvre par un dispositif (1) selon l'une quelconque des revendications précédentes, selon lequel on applique une force d'appui constante compris entre 0.1 et 2N.

8. Procédé selon la revendication 7, selon lequel on applique une force d'appui constante compris entre 0.3 N et 1N.

9. Procédé selon la revendication 7 ou 8, selon lequel au moins une partie de la force d'appui est générée par une pression de gaz appliquée sur les pointes.

10. Procédé selon l'une des revendications 7 à 9, selon lequel on déplace le support à une vitesse comprise entre 5 et 100 mm/s.

**Patentansprüche**

1. Vorrichtung (1) zur mechanischen Texturierung einer Siliziumscheibe (4), welche zur Bildung einer photovoltaischen Zelle bestimmt ist, wobei die Vorrichtung eine Vielzahl von Spitzen (3, 30, 31) aus Wolframkarbid sowie einen Träger (2) aufweist, welcher eine Vielzahl von Sitzen (20) umfasst, welche jeweils zur verschiebbaren Aufnahme einer Spitze aus Wolframkarbid ausgelegt sind, und Mittel, um jede der Vielzahl von Spitzen gegen die Siliziumscheibe gemäß einer konstanten Kraft unabhängig von Schwankungen der Dicke der Scheibe in Auflage zu halten.

2. Vorrichtung nach Anspruch 1, in welcher der Träger derart ausgelegt ist, dass er die Spitzen im losen Schiebesitz bzw. frei verschiebbar aufnimmt.

3. Vorrichtung nach Anspruch 2, in welcher die Mittel, welche die Spitzen in Auflage halten, durch das Eigengewicht jeder der Spitzen (3, 30, 31) gebildet werden.

4. Vorrichtung nach einem der Ansprüche 1 bis 3, in welcher die Spitzen einen unteren Abschnitt (31) in Form eines geraden Prismas mit dreieckiger Grundform aufweisen, dessen Scheitelwinkel kleiner ist als der Scheitelwinkel (200) der Sitze (20), welche zur Aufnahme bzw. Unterbringung der Spitzen ausgelegt sind..

5. Vorrichtung nach Anspruch 4, in welcher der Scheitelwinkel des Dreiecks der Spitzen (31) zwischen 30 und 45° beträgt.

6. Vorrichtung nach einem der vorhergehenden Ansprüche, in welcher der Schritt des Ätzens d zwischen 5$\mu$m und

40μm beträgt.

7. Verfahren zur mechanischen Texturierung einer Siliziumscheibe (4), welche zur Bildung einer photovoltaischen Zelle bestimmt ist, wobei das Verfahren von einer Vorrichtung (1) gemäß einem der vorhergehenden Ansprüche implementiert wird, gemäß welcher eine konstante Stütz- bzw. Auflagekraft zwischen 0,1 und 2N eingesetzt wird.

8. Verfahren nach Anspruch 7, gemäß welchem eine konstante Stütz- bzw. Auflagekraft zwischen 0,3N und 1 N eingesetzt wird.

9. Verfahren nach Anspruch 7 oder 8, gemäß welchem zumindest ein Teil der Stütz- bzw. Auflagekraft durch einen auf die Spitzen aufgebrachten Gasdruck erzeugt wird.

10. Verfahren nach einem der Ansprüche 7 bis 9, gemäß welchem der Träger in einer Geschwindigkeit zwischen 5 und 100 mm/s verschoben bzw. verlagert wird.


**Claims**

1. A device (1) for mechanical texturing of a silicon wafer (4) which is intended to constitute a photovoltaic cell, including multiple tungsten carbide points (3, 30, 31) and a support (2) including multiple recesses (20), each of which is able to hold a tungsten carbide point such that it can slide, and means to keep each of the multiple points pressed against the silicon wafer with a constant force which is independent of the thickness variations of the said wafer.

2. A device according to claim 1, in which the support is able to hold the points such that they can slide freely.

3. A device according to claim 2, in which the means applying a pressing force consist of the inherent weight of each of the points (3, 30, 31).

4. A device according to one of the claims 1 to 3, in which the points have a lower portion (31) in the form of a straight prism with a triangular base, the angle at the apex of which being less than that (200) of the recesses (20) able to hold them.

5. A device according to claim 4, in which the angle at the apex of the triangle of the points (31) is between 30 and 45°.

6. A device according to one of the previous claims, in which etching interval d is between 5 μm and 40 μm.

7. A method for mechanical texturing of a silicon wafer (4), intended to constitute a photovoltaic cell, implemented by a device (1) according to any of the previous claims, according to which a constant pressing force of between 0.1 and 2N is applied.

8. A method according to claim 7, according to which a constant pressing force of between 0.3 N and IN is applied.

9. A method according to claim 7 or 8, according to which at least a proportion of the pressing force is generated by a gas pressure applied on the points.

10. A method according to one of the claims 7 to 9, according to which the support is moved at a speed of between 5 and 100 mm/s.

**FIG.1**

FIG.2

FIG.3

EP 2 564 414 B1

**EP 2 564 414 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4821250 A

**Littérature non-brevet citée dans la description**

- **P. FATH ; C. BORST ; C. ZECHNER ; E. BUCHER ; G. WILLEKE ; S. NARAYANAN.** Progress in a novel high-throughput mechanical texturization technology for highly efficient multicrystalline silicon solar cells. *Solar Energy Materials and Solar Cells,* 1997, vol. 48, 229-236
- **L SANTINACCI ; T DJENIZIAN ; P SCHWAUER ; T SUTER ; A ETCHEBERRY ; P SCHMUKI.** Selective electrochemical gold deposition onto p-Si (100) surfaces. *J. Phys. D: Appl. Phys.,* 2008, vol. 41, 175301
- **D. KRAY ; M. SCHUMANN ; A. EYER ; G. P. WILLEKE ; R. KÜBLER ; J. BEINERT ; G. KLEER.** Solar wafer slicing with loose and fixed grains. *Proc. 2006 'IEEE 4th World Conference on Photovoltaic Energy Conversion,* 07 Mai 2006, vol. 1, 948-951
- **J.R. DAVIS, JR et al.** Impurities in silicon solar cells. *IEEE Transactions on Electron Devices,* 1980, vol. 27, 677-687